Europäisches Patentamt

European Patent Office

Office européen des brevets

(19)

(11) Veröffentlichungsnummer : **0 105 189**
**B1**

(12)  **EUROPÄISCHE PATENTSCHRIFT**

(45) Veröffentlichungstag der Patentschrift :
30.12.86

(51) Int. Cl.⁴ : **H 01 L 21/28**, H 01 L 23/48, H 01 L 29/74

(21) Anmeldenummer : 83108551.9

(22) Anmeldetag : 30.08.83

(54) Verfahren zum Herstellen von Metallelektroden unterschiedlicher Dicke für Halbleiterbauelemente, insbesondere für Leistungshalbleiterbauelemente wie Thyristoren.

(30) Priorität : 03.09.82 DE 3232837

(43) Veröffentlichungstag der Anmeldung :
11.04.84 Patentblatt 84/15

(45) Bekanntmachung des Hinweises auf die Patenterteilung : 30.12.86 Patentblatt 86/52

(84) Benannte Vertragsstaaten :
CH DE FR GB IT LI NL SE

(56) Entgegenhaltungen :
EP-A- 0 013 728
DE-A- 2 047 799
DE-A- 2 555 299
DE-B- 2 431 506
IBM TECHNICAL DISCLOSURE BULLETIN, Band 21, Nr. 3,August 78, New York S. KRONGELB "Control of edge build-up in sputter etching and ion milling", Seiten 1253-1255.

(73) Patentinhaber : Siemens Aktiengesellschaft Berlin und München
Wittelsbacherplatz 2
D-8000 München 2 (DE)

(72) Erfinder : Herberg, Helmut, Dr.
Kobellstrasse 12
D-8000 München 2 (DE)

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die vorliegende Patentanmeldung betrifft ein Verfahren zum Herstellen von Metallelektroden unterschiedlicher Dicke für Halbleiterbauelemente, insbesondere für Leistungshalbleiterbauelemente wie Thyristoren unter Verwendung von Fotolithographieschritten mit Fotolacken mit unterschiedlichen Belichtungseigenschaften.

Leistungshalbleiterbauelemente müssen wegen der hohen Strombelastung mit Stempeln kontaktiert werden. Hierzu muß, insbesondere bei abschaltbaren Thyristoren oder bei Fingerstrukturen die Emittermetallisierung eine größere Dicke aufweisen (zum Beispiel 20 µm) als die Basismetallisierung (zum Beispiel 5 µm).

Es ist bekannt, eine solche Metallelektroden unterschiedlicher Dicke dadurch herzustellen, daß entweder ein Graben geätzt wird und eine Einfachmetallisierung durchgeführt wird, oder daß aus Molybdän oder Silber bestehende Ronden auf die Elektrodenflächen aufgelegt werden. Andere Möglichkeiten bestehen darin, daß nacheinander zwei Ätzprozesse durchgeführt werden, oder daß einer der beiden Kontakte verstärkt wird. Diese Verfahren sind relativ aufwendig und ungenau.

Ein Verfahren der eingangs genannten Art für die Herstellung der Hilfsemitter- und Emitterelektroden eines Thyristors ist aus der deutschen Patentschrift 24 31 506 zu entnehmen. Bei diesem Verfahren wird der Halbleiterkörper des Thyristors mit einer Metallschicht von der Dicke der Emitterelektrode bedeckt, dann mittels einer ersten Fotomaskierung ein aus einem ersten fotoempfindlichen Lack bestehendes erstes Muster aufgebracht, dessen Form der Form der Emitterelektrode und der Form der Steuerelektrode entspricht und mittels einer zweiten Fotomaskierung ein zweites, der Form der Hilfsemitterelektrode entsprechendes Muster aufgebracht, das aus einem anderen fotoempfindlichen Lack besteht, dessen Lösungsmittel den ersten fotoempfindlichen Lack nicht löst. Anschließend werden durch eine erste Ätzung die unmaskierten Bereiche der Metallschicht abgeätzt, das zweite Muster abgelöst und die Hilfsemitterelektrode durch eine zweite Ätzung auf die gewünschte Dicke gebracht. Als Metallisierung wird Aluminium, als erste Lackschicht Negativlack, als zweite Lackschicht Positivlack verwendet.

Das aus der DE-C-24 31 506 bekannte Verfahren beschreibt eine Arbeitsweise, die mit zwei verschiedenen Fotolacken arbeitet und den großen Vorteil besitzt, Fotolacke nur auf ebenen Schichten zu verwenden, das heißt, Kantenbedeckungsprobleme treten bei 20 µm hohen Metallschichten nicht auf. Schwierigkeiten entstehen aber dadurch, daß eine gleichmäßige Ätzung einer 5 bis 15 µm dicken Aluminiumschicht über eine größere Fläche (Durchmesser 50 bis 100 mm) nicht zu erreichen ist.

Die Aufgabe, die der vorliegenden Erfindung zugrundeliegt, besteht darin, diese Schwierigkeiten zu beseitigen und ein Verfahren anzugeben, mit dem eine bezüglich der jeweiligen Schichtdicke gleichmäßige Metallisierung möglich ist. Insbesondere soll bei der Herstellung von druckkontaktierten Thyristoren, bei denen die Emittermetallisierung eine größere Dicke hat als die Basiskontaktierung, die Basismetallisierung über die ganze Substratscheibe eine reproduzierbare Dicke aufweisen.

Diese Aufgabe wird durch ein Verfahren der eingangs genannten Art dadurch gelöst, daß als Metallisierung eine mindestens drei Schichten enthaltende Metallkombination, von denen mindestens eine Zwischenschicht bezüglich chemischer Lösungsmittel ein anderes Lösungsverhalten aufweist als die oberste und unterste Schicht der Metallkombination verwendet und teilweise einem Lösungsmittel für die oberste Schicht ausgesetzt wird. Es gehört zu den besonderen Ausführungsarten der Erfindung, daß die oberste und unterste Schicht aus dem gleichen Metall bestehen und daß die Schichtenfolge Aluminium/Silber/Aluminium verwendet wird. Dabei ist vorgesehen, daß das Schichtdickenverhältnis auf 2 : 1 : 2 eingestellt wird.

Weitere Ausgestaltungen des erfindungsgemäßen Verfahrens ergeben sich aus den Unteransprüchen.

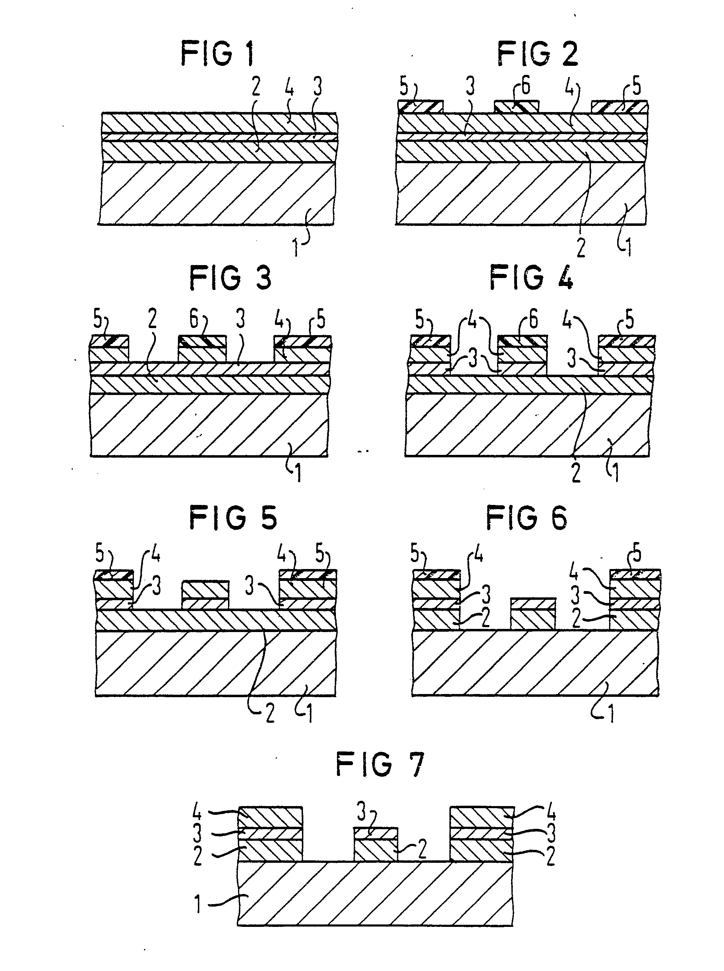

Im folgenden wird anhand eines Ausführungsbeispiels in Verbindung mit den Figuren 1 bis 7 die Erfindung noch näher erläutert. Dabei zeigen die Figuren im Schnittbild die jeweiligen aufeinanderfolgenden Verfahrensschritte zur Herstellung einer 2-Ebenen-Metallisierung ; für gleiche Teile sind gleiche Bezugszeichen verwendet.

Das in Figur 1 mit dem Bezugszeichen 1 bezeichnete Substrat enthält die Thyristorstruktur, auf die hier nicht näher eingegangen werden soll. Auf das Substrat 1 wird zunächst eine Aluminiumschicht 2 in einer Schichtdicke von beispielsweise 8 µm aufgedampft, darauf eine Silberschicht 3 von 4 µm Dicke und auf diese wieder eine Aluminiumschicht 4 von 8 µm Dicke aufgebracht.

Darauf wird, wie in Figur 2 dargestellt, zuerst eine aus einem negativ-arbeitenden Fotolack bestehende Schichtstruktur 5 und anschließend daran auf der gleichen Ebene eine aus einem positiv-arbeitenden Fotolack bestehende Schichtstruktur 6 erzeugt.

Dann wird, wie aus Figur 3 ersichtlich, mit einen Ätzmittel, welches die Silberschicht 3 nicht angreift, die oberste, 8 µm dicke Aluminiumschicht 4 in den nicht von den Fotolackstrukturen 5 und 6 bedeckten Bereichen weggeätzt. Als Ätzmittel dient verdünnte Salzsäure oder heiße Phosphorsäure.

Anschließend wird die von den Fotolackstrukturen 5 und 6 nicht bedeckte Silberschicht 3 mit einem Ätzmittel, welches Aluminium nicht löst, zum Beispiel Salpetersäure, entfernt, so daß die in Figur 4 dargestellte Anordnung entsteht.

Figur 5 zeigt die Anordnung nach Ablösen der Positivlackstrukturen 6.

Unter Ausnutzung des Ätzstops am Siliziumsubstrat 1 und an der Silberschicht 3 wird nun eine zweite Salzsäure oder Phosphorsäureätzung durchgeführt und die nicht von der Negativlackstruktur 5 bedeckte erste Aluminiumschicht 2 (8 μm) weggeätzt (siehe Figur 6).

Abschließend wird, wie aus Figur 7 zu ersehen ist, auch die Negativlackstruktur 5 entfernt.

Die Metallschichtfolge kann in einem zusätzlichen Verfahrensschritt noch in einer inerten Atmosphäre bei 400-500 °C gesintert werden.

Trotz aller Unzulänglichkeiten eines Ätzprozesses läßt sich eine gleichmäßige Basismetallisierung erzielen.

Das Verfahren ist auch bei allen Halbleiterbauelementen, das heißt, Transistoren anwendbar, die eine starke Verzahnung von Emitter- und Basisanschlüssen erfordern.


**Patentansprüche**

1. Verfahren zum Herstellen von Metallelektroden unterschiedlicher Dicke für Halbleiterbauelemente, insbesondere für Leistungshalbleiterbauelemente wie Thyristoren, unter Verwendung von Fotolithographieschritten mit Fotolacken mit unterschiedlichen Belichtungseigenschaften, dadurch gekennzeichnet, daß als Metallisierung eine mindestens drei Schichten (2, 3, 4) enthaltende Metallkombination, von denen mindestens eine Zwischenschicht (3) bezüglich chemischer Lösungsmittel ein anderes Lösungsverhalten aufweist als die oberste (4) und die unterste Schicht (2) der Metallkombination, verwendet und teilweise einem Lösungsmittel für die oberste Schicht ausgesetzt wird.

2. Verfahren nach Anspruch 1, dadurch gekennzeichnet, daß eine aus drei Schichten (2, 3, 4) bestehende Metallkombination verwendet wird, von denen die unterste (2) und oberste Schicht (4) aus dem gleichen Metall bestehen.

3. Verfahren nach Anspruch 1 und/oder 2, dadurch gekennzeichnet, daß die Schichtenfolge (2, 3, 4) Aluminium/Silber/Aluminium verwendet wird.

4. Verfahren nach Anspruch 3, dadurch gekennzeichnet, daß das Schichtdickenverhältnis auf 2 : 1 : 2 eingestellt wird.

5. Verfahren zur Herstellung eines druckkontaktierten Thyristors, bei dem die Emittermetallisierung eine größere Dicke aufweist als die Basismetallisierung nach Anspruch 1 bis 4, gekennzeichnet durch den Ablauf der folgenden Verfahrensschritte :

a) Aufbringen der aus Aluminium (2)/Silber (3)/Aluminium (4) bestehenden Schichtkombination auf das für die Metallisierung vorgesehene Substrat (1),

b) Durchführung einer ersten Fotolacktechnik mit einem Negativlack zur Festlegung der Emittermetallisierung, wobei der Emitterbereich mit Negativlackstrukturen (5) bedeckt bleibt,

c) Durchführung einer zweiten Fotolacktechnik mit einem Positivlack zur Festlegung der Basismetallisierung, wobei der Basisbereich mit der Positivlackstruktur (6) bedeckt bleibt,

d) Abätzen der obersten Aluminiumschicht (4) an den nicht mit Fotolackstrukturen (5, 6) bedeckten Stellen des Substrats (1, 2, 3) mit einem, die Silberzwischenschicht (3) nicht angreifenden Lösungsmittel,

e) Abätzen der Silberzwischenschicht (3) an den nicht mit Fotolackstrukturen (5, 6) bedeckten Stellen des Substrats (1, 2) mit einem Lösungsmittel, gegen das Aluminium resistent ist,

f) Entfernen der Positivlackstrukturen (6),

g) Abätzen der Aluminiumschicht (2) an den nicht mit Negativlackstrukturen (5) bedeckten Stellen des Substrats (1) mit einem Lösungsmittel, gegen das Silber und Silizium resistent ist,

h) Entfernen der Negativlackstrukturen (5) (Figur 1 bis 7).

6. Verfahren nach Anspruch 5, dadurch gekennzeichnet, daß in einem zusätzlichen Verfahrensschritt die Metallisierung in inerter Atmosphäre bei 400-500 °C gesintert wird.

7. Verfahren nach Anspruch 5 und/oder 6, dadurch gekennzeichnet, daß als Lösungsmittel für die Aluminiumschicht (2, 4) nach Verfahrensschritt d) und g) verdünnte Salzsäure oder heiße Phosphorsäure verwendet wird.

8. Verfahren nach Anspruch 5 bis 7, dadurch gekennzeichnet, daß als Lösungsmittel für die Silberschicht (3) nach Verfahrensschritt e) Salpetersäure verwendet wird.

9. Verfahren nach Anspruch 5 bis 8, dadurch gekennzeichnet, daß die Schichtdicke der untersten und der obersten, aus Aluminium bestehenden Schichten (2, 4) auf je 8 μm und die der Silberzwischenschicht (3) auf 4 μm eingestellt wird.

10. Verwendung des Verfahrens nach Anspruch 1 bis 9 zur Herstellung von abschaltbaren Thyristoren.

11. Verwendung des Verfahrens nach Anspruch 1 bis 9 zur Herstellung von Transistoren, die eine starke Verzahnung von Emitter- und Basisanschlüssen erfordern.


**Claims**

1. A method of producing metal electrodes of different thickness for semiconductor components, in particular for power semiconductor components, such as thyristors, using photolithographical steps with photo-lacquers of different exposure properties, characterised in that a metal combination, which comprises at least three layers (2, 3, 4), is used as metallization, at least one intermediate layer (3) of which layers has a different dissolving behaviour with respect to chemical solvents than the topmost (4) and the lowermost layer (2) of the metal combination, and is partially subjected to a solvent for the topmost layer.

2. A method as claimed in Claim 1, characterised in that a metal combination which consists of three layers (2, 3, 4) is used, the lowermost (2) of which layers and the uppermost layer (4) consist of the same metal.

3. A method as claimed in Claim 1 and/or Claim 2, characterised in that for the layer sequence (2, 3, 4), aluminium/silver/aluminium is used.

4. A method as claimed in Claim 3, characterised in that the ratio of the layer thickness is set at 2 : 1 : 2.

5. A method of producing a pressure-contacted thyristor, in which the emitter metallization has a greater thickness than does the base metallization, as claimed in Claim 1 to 4, characterised by the sequence of the following process steps :

a) application of the layer combination consisting of aluminium (2)/silver (3)/aluminium (4) onto the substrate (1) provided for the metallization,

b) carrying out a first photo-lacquer technique using a negative lacquer in order to define the emitter metallization, the emitter zone remaining covered with negative lacquer structures (5),

c) carrying out a second photo-lacquer technique using a positive lacquer in order to define the base metallization, the base zone remaining covered with the positive lacquer structure (6),

d) etching the uppermost aluminium layer (4) at the positions on the substrate (12, 2, 3) which are not covered with photo-lacquer structures (5, 6) , by means of a solvent which does not attack the intermediate silver layer (3),

e) etching the intermediate silver layer (3) at the positions on the substrate (1, 2) which are not covered with photo-lacquer structures (5, 6), by means of a solvent to which aluminium is resistant,

f) removing the positive lacquer structures (6),

g) etching the aluminium layer (2) at the positions on the substrate (1), which are not covered with negative lacquer structures (5), by means of a solvent to which silver and silicon are resistant,

h) removing the negative lacquer structures (5) (Figure 1 to 7).

6. A method as claimed in Claim 5, characterised in that, in an additional process step, the metallization is sintered in an inert atmosphere at 400-500 °C.

7. A method as claimed in Claim 5 and/or Claim 6, characterised in that dilute hydrochloric acid or hot phosphoric acid is used as solvent for the aluminium layer (2, 4) in steps d) and g).

8. A method as claimed in Claim 5 to 7, characterised in that nitric acid is used as solvent for the silver layer (3) in step e).

9. A method as claimed in Claim 5 to 8, characterised in that the layer thickness of the lowermost and uppermost layers (2, 4) consisting of aluminium is in each case set at 8 $\mu$m and that of the intermediate silver layer (3) at 4 $\mu$m.

10. The use of the method as claimed in Claim 1 to 9 for producing switchable thyristors.

11. The use of the method as claimed in Claim 1 to 9 for the production of transistors which require a strong indentation of emitter and base terminals.

**Revendications**

1. Procédé pour fabriquer des électrodes métalliques de différentes épaisseurs pour dispositifs à semiconducteurs, en particulier pour dispositifs à semiconducteurs de puissance, tels que des thyristors, en appliquant des opérations photolithographiques avec des résines photosensibles ayant des caractéristiques d'exposition différentes, caractérisé en ce que l'on utilise, comme métallisation, une combinaison de métaux comprenant au moins trois couches (2, 3, 4) dont au moins une couche intermédiaire (3) présente un autre comportement de dissolution, pour des solvants chimiques, que la couche supérieure (4) et la couche inférieure (2) de la combinaison de métaux, et on expose la combinaison de métaux partiellement à un solvant pour la couche supérieure.

2. Procédé selon la revendication 1, caractérisé en ce que l'on utilise une combinaison de métaux constituée de trois couches (2, 3, 4) dont la couche inférieure (2) et la couche supérieure (4) sont formées du même métal.

3. Procédé selon la revendication 1 et/ou 2, caractérisé en ce que l'on utilise la succession de couches (2, 3, 4) aluminium/argent/aluminium.

4. Procédé selon la revendication 3, caractérisé en ce que l'on ajuste les rapports des épaisseurs des couches à 2 : 1 : 2.

5. Procédé pour fabriquer un thyristor à contacts par pression, sur lequel la métallisation d'émetteur possède une plus forte épaisseur que la métallisation de base, selon les revendications 1 à 4, caractérisé par l'exécution des opérations suivantes :

a) application de la combinaison de couches d'aluminium (2)/argent (3)/aluminium (4) sur le substrat (1) prévu pour la métallisation,

b) exécution d'une première opération à résine photosensible, avec une résine négative, pour fixer la métallisation d'émetteur, dans laquelle la région d'émetteur reste couverte de structures de résine négative (5),

c) exécution d'une deuxième opération à résine photosensible, avec une résine positive, pour fixer la métallisation de base, dans laquelle la région de base reste couverte par la structure de résine positive (6),

d) élimination par gravure de la couche d'aluminium supérieure (4), aux endroits non recouverts de structures de résine photosensible (5, 6) du substrat (1, 2, 3), au moyen d'un solvant n'attaquant pas la couche intermédiaire d'argent (3),

e) élimination par gravure de la couche d'argent (3) aux endroits non recouverts de structures de résine photosensible (5, 6) du substrat (1, 2), au moyen d'un solvant auquel l'aluminium résiste,

f) enlèvement des structures de résine positive (6),

g) élimination par gravure de la couche d'aluminium (2), aux endroits non recouverts de structures de résine négative (5) du substrat (1), au moyen d'un solvant auquel l'argent et le silicium résistent,

h) enlèvement des structures de résine négative (5) (figures 1 à 7).

6. Procédé selon la revendication 5, caractérisé en ce que, dans une opération supplémentaire, on produit le frittage de la métallisation dans une atmosphère inerte à 400-500 °C.

7. Procédé selon la revendication 5 et/ou 6, caractérisé en ce que l'on utilise de l'acide chlorhydrique dilué ou de l'acide phosphorique chaud comme solvant pour la couche d'aluminium (2, 4) selon les opérations d) et g).

8. Procédé selon les revendications 5 à 7, caractérisé en ce que l'on utilise de l'acide nitrique comme solvant pour la couche d'argent (3) selon l'opération e).

9. Procédé selon les revendications 5 à 8, caractérisé en ce que l'on ajuste l'épaisseur des couches inférieure et supérieure (2, 4) en aluminium, à 8 $\mu$m chacune et celle de la couche intermédiaire en argent (3) à 4 $\mu$m.

10. Utilisation du procédé selon les revendications 1 à 9 pour fabriquer des thyristors blocables.

11. Utilisation du procédé selon les revendications 1 à 9 pour fabriquer des transistors exigeant une forte imbrication de bornes d'émetteur et de base.

FIG 1

FIG 2

FIG 3

FIG 4

FIG 5

FIG 6

FIG 7